# EUROPEAN PATENT SPECIFICATION

(11) **EP 2 807 648 B1**
(45) Date of publication and mention of the grant of the patent: **06.04.2016**
(21) Application number: 13706101.6
(22) Date of filing: 23.01.2013
(51) Int. Cl.: G11C 11/15, G11C 11/16, H01L 43/08, H01L 43/12

(54) **MULTI-BIT MAGNETIC TUNNEL JUNCTION MEMORY AND METHOD OF FORMING THE SAME**
MULTI-BIT MAGNETTUNNELÜBERGANGSSPEICHER UND DESSEN HERSTELLUNGSVERFAHREN
MEMOIRE DE JONCTION À EFFET TUNNEL MAGNÉTIQUE MULTIBITS ET SON PROCEDE DE FORMATION DU MEMOIRE

(30) Priority: 23.01.2012 US 201213356530
(43) Date of publication of application: 03.12.2014
(73) Proprietor: Qualcomm Incorporated, San Diego, CA 92121 (US)
(72) Inventor: WU, Wenqing, San Diego, California 92121 (US); LI, Sean, San Diego, California 92121 (US); ZHU, Xiaochun, San Diego, California 92121 (US); MADALA, Raghu Sagar, San Diego, California 92121 (US); KANG, Seung H., San Diego, California 92121 (US); YUEN, Kendrick H., San Diego, California 92121 (US)
(74) Representative: Catesby, Olivia Joanne
(86) International application number: PCT/US2013/022789
(87) International publication number: WO 2013/112615

(56) References cited:
- JP-A- 2003 188 439
- JP-A- 2006 196 613
- US-A1- 2010 013 035

## Description

### Field of the Invention

The present invention is directed toward a multi-bit magnetic tunnel junction memory and toward a method of forming same, and, more specifically, toward a multi-bit magnetic tunnel junction memory having a plurality of free magnetic elements associated with a unitary fixed magnetic layer and toward a method of forming same.

### Background

A spin-torque transfer (STT) magnetic tunnel junction (MTJ) element comprises a fixed magnetic layer, the magnetic state of which is fixed, and a free magnetic layer, the magnetic state of which is selectively reversible. The fixed and free layers are separated by a magnetic barrier or junction layer. The STT-MTJ element is switchable between two mutually opposite, stable magnetization states - "parallel" (P) and "anti-parallel" (AP), by passing an electric write current through its layers. If the write current is above a given critical point the STT-MTJ will switch into the P or AP state induced by the direction of the write current. A conventional STT-MTJ memory cell stores one bit, with one of the P and AP states assigned to represent a first binary value, e.g., a "0", and the other assigned to represent a second binary value, e.g., a "1." The stored binary value can be read because STT-MTJ elements have a lower electrical resistance in the P state than the AP state.

Conventional STT-MTJ memory employs write circuitry designed to inject a write current having a magnitude high enough and duration long enough to ensure it switches the STT-MTJ element to the desired P/AP state. Conventional design philosophy for STT-MTJ memory is therefore a "deterministic" writing confined to the design paradigm of conventional memories, such as SRAM, where the switching of memory elements is deterministic.

It is also known to provide a cluster of STT-MTJ cells to form a memory element that can take on one of a plurality of different states depending on how many of the STT-MTJ cells are in a parallel states and how many of the STT-MTJ cells are in an anti-parallel state. A cluster having N STT-MTJ cells can take on any one of 2ⁿ different states and thus present one of 2ⁿ different resistances to a measurement circuit. Such a measurement only requires access to the input and output of the overall STT-MTJ cluster and does not require access to or knowledge of the states of any of the individual STT-MTJ cells.

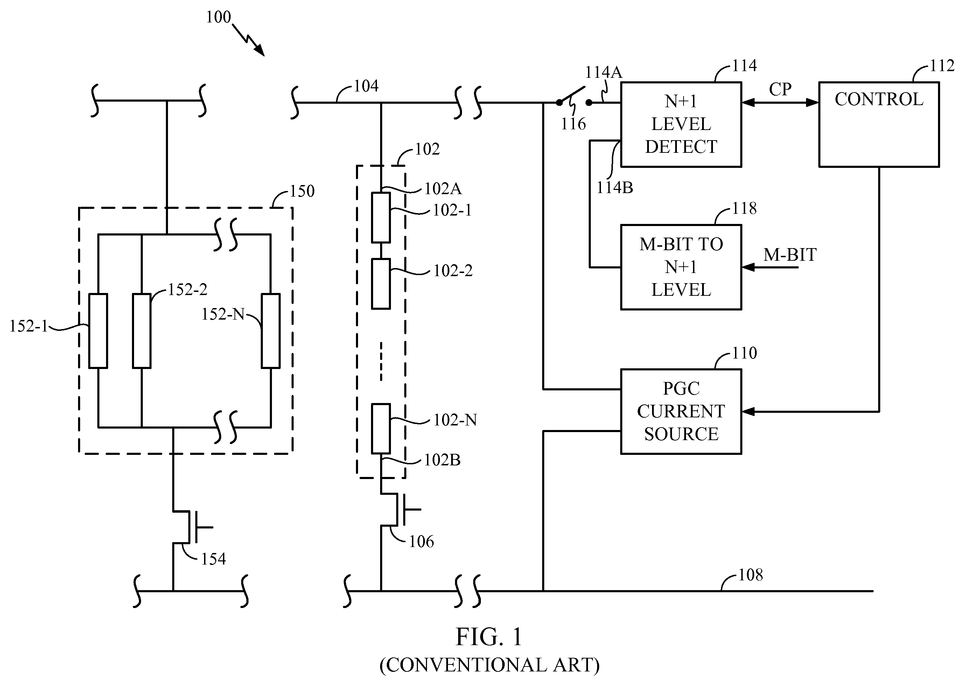

FIG. 1 shows a circuit 100 that includes an N-element STT-MTJ cluster cell 102 comprising N STT-MTJ elements 102-1, 102-2 ... 102-N connected in series. The N-element STT-MTJ cluster cell 102 is coupled at one end 102A to a read/write current (BL) line 104 and coupled at its other end 102B through an enabling switch 106 to another read/write current (SL) line 108. Figure 1 also includes an N-element STT-MTJ cluster cell 150 comprising N STT-MTJ elements 152-1,152-2 ... 152-N connected in parallel and connected to the SL line 108 via an enabling switch 154. It will be understood that the BL line 104 and the SL line 108 may extend and couple to each of a plurality of additional STT-MTJ clusters (not shown). The BL line 104 and the SL line 108 may be in accordance with conventional *n x m* array STT-MTJ memory bit line and source line. Likewise the enabling switch 106 may be in accordance with a conventional *n x m* array STT-MTJ memory word enable switch. It will also be understood that the BL line 104, the SL line 108, and the enabling switch may be other than convention bit lines, source lines and word transistors, respectively.

A probabilistic programming current (PGC) source 110 controlled by a probabilistic programming (PPG) controller unit 112 couples to the BL line 104 and to the SL line 108. An N+1 level voltage detector 114 may have a sense input 114A coupled to the BL line 104 though a read enabling switch 116, and a sense input 114B coupled to an M-bit to N+1 level converter 118. The M-bit data to N+1 level converter 118 may convert the M-bit data into an N+1 level target resistance voltage signal. The N+1 level converter 118 may provide a compare signal to the PPG controller 112. It will be understood that the N+1 level voltage detector 114 may include a read current source (not explicitly shown) to inject a read current via the BL line 104 through the N-element STT-MTJ cluster cell 102.

In operation, the PPG controller 112 causes the PGC current source 110 to apply a current to the SL line 108 and the enabling switch 106 is activated to apply this current to the N-element STT-MTJ cluster cell 102. The current level and duration are selected such that, with each current application, there is a predetermined chance of switching the state of one of the N STT-MTJ elements 102-1 through 102-N from a first state to a second state, based on the direction of the current. After a current is applied, the N+1 level voltage detector 114 measures the resistance of the N-element STT-MTJ cluster cell 102 to determine how many of the STT-MTJ cells are in the desired state, and current is applied in a required direction until the desired resistance level of the N- element STT-MTJ cluster cell 102 is obtained. In this manner, the N-element STT-MTJ cluster cell 102 can represent 2" bits of information. The N-element STT-MTJ cluster cell 150 may be controlled and used to store multiple bits of data in a similar manner.

STT-MTJ cell clusters as discussed above are useful to provide multi-bit storage in a given area. It is desirable to increase the density of STT-MTJ elements in an STT- MTJ cluster while maintaining the aforementioned functionalities.

JP2006196613 (A) discloses a storage device which is capable of reducing a recording current by spin transfer through a process of forming a memory layer as a sufficiently thin continuous film by a stable technique in a manufacturing process. The storage device has a configuration wherein the memory layer holding information by the magnetization state of a magnetic material, a non-magnetic layer, and a magnetization stationary layer are laminated together, information is written in the memory layer through a process of making a current flow in the direction of lamination, and a mixed layer region composed of a ferromagnetic material and a non-magnetic material is formed near an interface between the memory layer and its adjoining layer opposite to the non-magnetic layer.

JP2003188439 (A) discloses how to achieve low power consumption when a magnetic memory device is configured by enabling, for a free layer provided in a magneto-resistive effect element, the control of rotary magnetic field without technical difficulty and limitation to reduction in thickness of the free layer. The magneto-resistive effect element is formed by laminating at least a ferromagnetic free layer, a non-magnetic layer and a ferromagnetic fixed layer. In this magneto-resistive effect element, a value of the rotary magnetic field at the free layer can be controlled by the growth of the free layer up to the thickness enough to attain the continuation thereof, the formation of a mixed layer region, which has extremely reduced or perfectly eliminated magnetism, to a part of the free layer, and substantial reduction in thickness of the free layer to show its function as much as the thickness of the mixed layer region.

US2010013035 (A1) discloses an integrated circuit that includes a plurality of magnetic tunneling junction stacks, each magnetic tunneling junction stack including a reference layer, a barrier layer and a free layer, wherein the plurality of magnetic tunneling junction stacks share a continuous common reference layer.

### SUMMARY

An exemplary embodiment includes a spin-torque transfer (STT) magnetic tunnel junction (MTJ) memory according to the independent device claim 1.

Another embodiment comprises a method of forming an STT-MTJ memory according to the independent method claim 12.

### BRIEF DESCRIPTION OF THE DRAWINGS

The accompanying drawings are presented to aid in the description of the invention.
FIG. 1 is a circuit diagram illustrating first and second conventional STT-MTJ cluster cell memory arrangements in a probabilistic programming circuit.
FIG. 2 is a schematic illustration of an STT-MTJ cluster cell memory.
FIG. 3 is a schematic illustration of an STT-MTJ cluster cell memory.
FIG. 4 is a schematic illustration of an STT-MTJ cluster cell memory.
FIG. 5 is a schematic illustration of an STT-MTJ cluster cell memory.
FIG. 6 is a schematic illustration of an STT-MTJ cluster cell memory according to an embodiment.
FIG. 7 is a schematic illustration of an STT-MTJ cluster cell memory according to an embodiment.

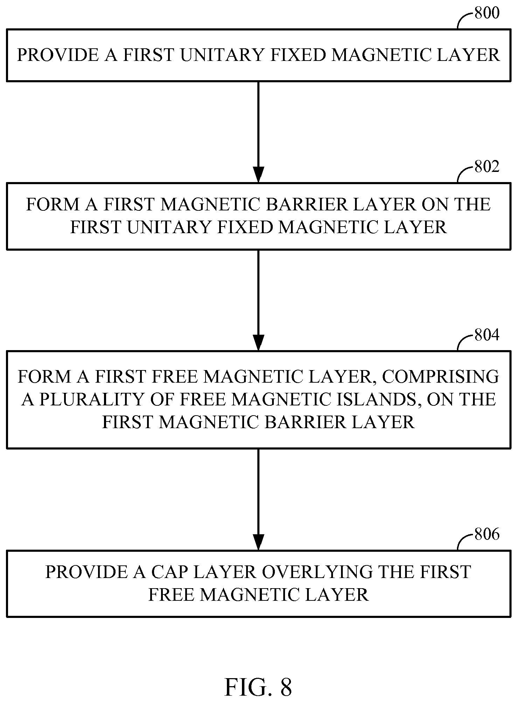

FIG. 8 is a flow chart illustrating a method according to an embodiment.

### DETAILED DESCRIPTION

Aspects of the invention are disclosed in the following description and related drawings directed to the invention. Additionally, well-known elements of the invention will not be described in detail or will be omitted so as not to obscure the relevant details of the invention.

The word "exemplary" is used herein to mean "serving as an example, instance, or illustration." Any embodiment described herein as "exemplary" is not necessarily to be construed as preferred or advantageous over other embodiments. Likewise, the term "embodiments of the invention" does not require that all embodiments of the invention include the discussed feature, advantage or mode of operation.

The terminology used herein is for the purpose of describing particular embodiments only and is not intended to be limiting of embodiments of the invention. As used herein, the singular forms "a", "an" and "the" are intended to include the plural forms as well, unless the context clearly indicates otherwise. It will be further understood that the terms "comprises", "comprising,", "includes" and/or "including", when used herein, specify the presence of stated features, integers, steps, operations, elements, and/or components, but do not preclude the presence or addition of one or more other features, integers, steps, operations, elements, components, and/or groups thereof.

Further, many embodiments are described in terms of sequences of actions to be performed by, for example, elements of a computing device. It will be recognized that various actions described herein can be performed by specific circuits (e.g., application specific integrated circuits (ASICs)), by program instructions being executed by one or more processors, or by a combination of both. Additionally, these sequence of actions described herein can be considered to be embodied entirely within any form of computer readable storage medium having stored therein a corresponding set of computer instructions that upon execution would cause an associated processor to perform the functionality described herein. Thus, the various aspects of the invention may be embodied in a number of different forms, all of which have been contemplated to be within the scope of the claimed subject matter. In addition, for each of the embodiments described herein, the corresponding form of any such embodiments may be described herein as, for example, "logic configured to" perform the described action.

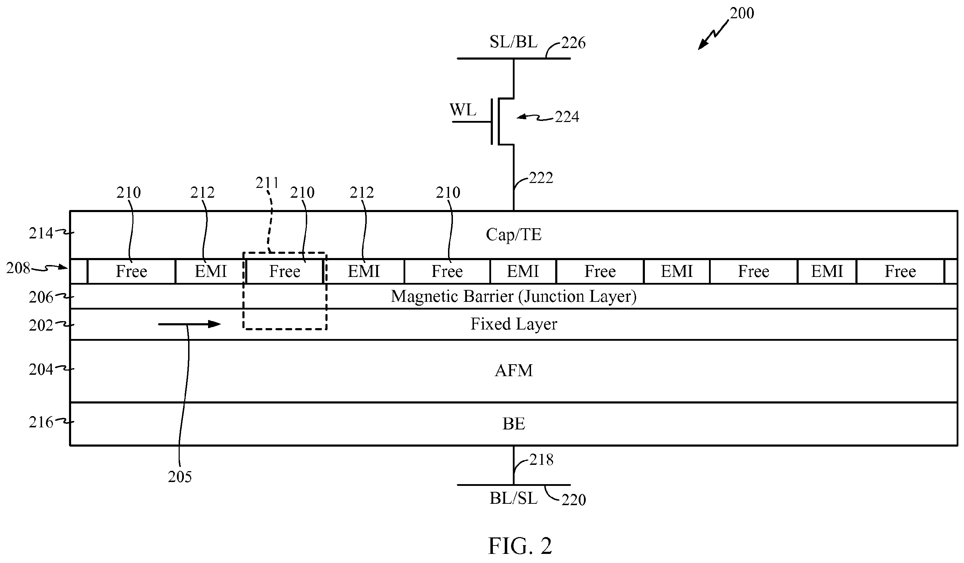

Referring now to Figure 2, an STT-MTJ cluster cell memory 200 is illustrated that includes a first unitary fixed magnetic layer 202 formed of a unitary layer of magnetic material and a first anti-ferromagnetic layer 204 on which the first unitary fixed magnetic layer 202 is formed. As used herein, "unitary" means that a layer, such as the first unitary fixed magnetic layer 202, is substantially and/or topologically continuous and is configured to be shared by a plurality of individual free magnetic regions as discussed hereafter. The magnetic direction of the first unitary fixed magnetic layer 202 is fixed in a first direction indicated by an arrow 205 or to the right as viewed in Figure 2.

A first magnetic barrier layer 206, sometimes referred to as a "junction layer," comprising a unitary layer of material, is formed on the first unitary fixed magnetic layer 202, and a first free magnetic layer 208 is formed on the first magnetic barrier layer 206. The first free magnetic layer 208 comprises a first plurality of individual free magnetic islands 210 each of which is in contact with the first magnetic barrier layer 206 but which are separated from one another by first regions 212 of electromagnetic insulating material. The first magnetic barrier layer 206 is substantially homogenous, and its properties are substantially similar in regions underlying the first free magnetic islands 210 and in regions beneath the first plurality of regions 212 of electromagnetic insulating material.

Each of the first plurality of free magnetic islands 210 has a footprint over the first unitary fixed magnetic layer 202 and forms, with the region of first magnetic barrier layer 206 between each of the first plurality of free magnetic islands 210 and the portion of the first unitary fixed magnetic layer 202 therebeneath, a magnetic tunnel junction 211. The general location of a single magnetic tunnel junction 211 is illustrated with a dashed outline in Figure 2; each of the remaining ones of the first plurality of free magnetic islands 210 is part of a similar magnetic tunnel junction 211. The magnetic tunnel junctions 211 formed by these layers thus share a common fixed magnetic layer, namely, the first unitary fixed magnetic layer 202, and a common magnetic barrier layer, namely, the first magnetic barrier layer 206. A cap layer 214 is formed over the first free magnetic layer 208 in direct contact with the first plurality of free magnetic islands 210 and the first plurality of regions 212 of electromagnetic insulating material.

Figure 2 illustrates six of the first plurality of free magnetic islands 210; however, it should be understood that the first plurality of free magnetic islands 210 in a given STT-MTJ cluster cell memory may comprise a greater or lesser number of free magnetic islands 210 without departing from the scope of the present disclosure. Moreover, while the first plurality of free magnetic islands 210 are illustrated as being arranged in a single straight line, such free magnetic islands 210 may cover the plane of the first magnetic barrier layer 206 and thus form an array or other pattern over the surface of the first magnetic barrier layer 206. It is generally desirable to make the individual free magnetic islands 210 as small and to space them as closely to one another as existing manufacturing conditions permit while maintaining an adequate spacing to substantially prevent the STT-MTJ's formed by the first plurality of free magnetic islands 210 from interfering with one another.

The aforementioned first anti-ferromagnetic layer 204 is mounted on a connection layer 216, which may be formed, for example, of tantalum, and a first line 218 is electrically connected to the connection layer 216 and to a bit line / source line 220. A second line 222 connects the cap layer 214 to a switch 224 which in turn is controllable to selectably connect the cap layer 214 to a source line / bit line 226. Like the connection layer 216, the cap layer 214 may be formed from tantalum, or, alternately, may include layers of tantalum and other materials such as ruthenium or magnesium oxide, or may be formed of tantalum nitride or titanium nitride. The bit line / source line 220 and the source line / bit line 226 are connected to a control circuit generally similar to the circuit illustrated in Figure 1, and current applied between the cap layer 214 and the connection layer 216 probabilistically changes the state of one or more of the STT-MTJ's in the STT-MTJ cluster cell memory 200 in the manner described above.

The use of a common or shared fixed magnetic layer in association with multiple free magnetic islands 210 beneficially lowers the energy required for switching an STT-MTJ, and the energy required for switching all the magnetic tunnel junctions 211 formed by the first plurality of free magnetic islands 210 is less than that required for switching an STT-MTJ having a free layer with an area equal to the combined areas of all the first plurality of free magnetic islands 210. Using unitary layers of material, such as the first unitary fixed magnetic layer 202 and the first magnetic barrier layer 206 also provides an improved yield and increases tolerance for manufacturing defects in these layers. Furthermore, the large area of the first unitary fixed magnetic layer 202 makes this layer more magnetically stable than individual regions of fixed magnetic material in conventional STT-MTJ's, and the size of the first unitary fixed magnetic layer 202 also increases the tunnel magnetoresistance of the STT-MTJ's formed by this layer.

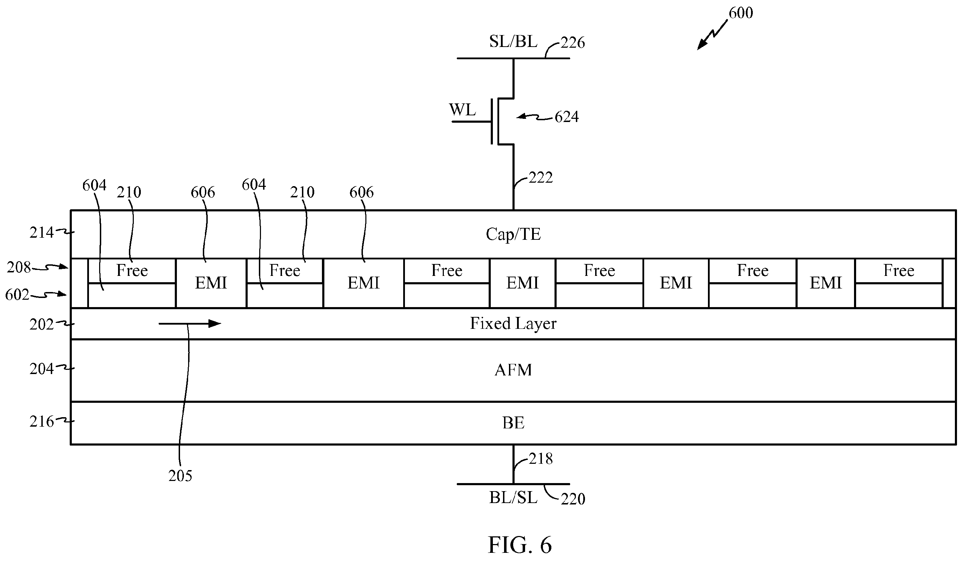

Figure 6 illustrates an STT-MTJ cluster cell memory 600 that is similar to the STT-MTJ cluster cell 200 memory of Figure 2 but in which a first magnetic barrier layer 602 comprises a plurality of individual barrier layer islands 604 beneath each of the first plurality of free magnetic islands 210 and in which regions 606 of electromagnetic insulating material extend from the cap layer 214 to the first unitary fixed magnetic layer 202. The cap layer 214 is connected to the source line / bit line 226 by a switch 624. The performance of the cluster cell 600 is comparable to that of the STT-MTJ cluster cell memory 200, but the STT-MTJ cluster cell memory 600 may be easier to manufacture than the STT-MTJ cluster cell memory 200 under certain manufacturing conditions.

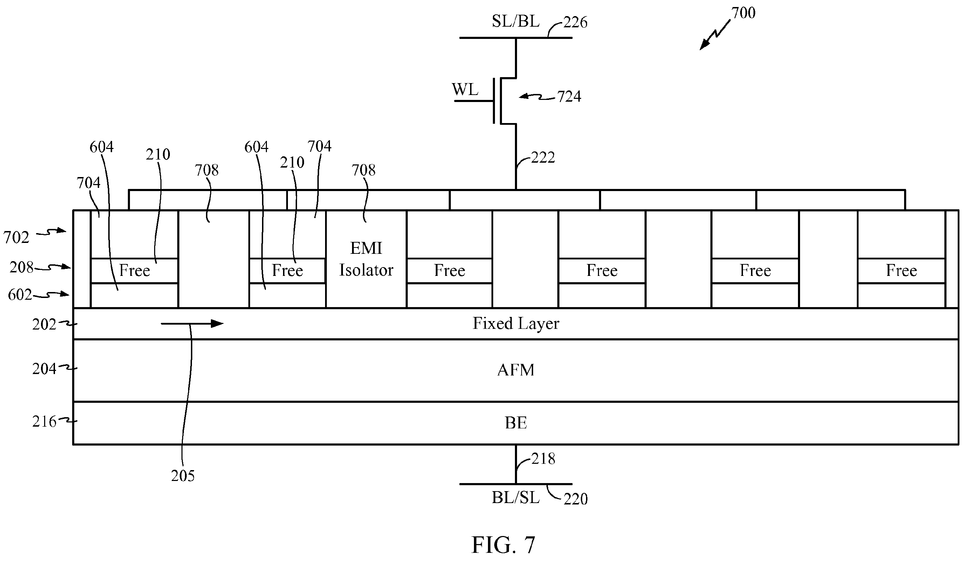

Figure 7 illustrates an STT-MTJ memory or cluster cell 700 that is similar to the STT-MTJ cluster cell memory 600 of Figure 6 and which includes a magnetic barrier layer 602 comprising a plurality of magnetic barrier islands 604. In addition, the STT-MTJ cluster cell 700 includes a cap layer 702 divided into a plurality of cap layer islands 704 each of which is connected to the source line / bit line 226 by a switch 724. Regions 708 of electromagnetic isolation material separate the adjacent cap layer islands 706, the adjacent free magnetic islands 210 and the adjacent magnetic barrier islands 604. The performance of this STT-MTJ cluster cell memory 700 may be similar to that of the STT-MTJ cluster cell memories 200 and 600 but, under some conditions, may be easier to manufacture.

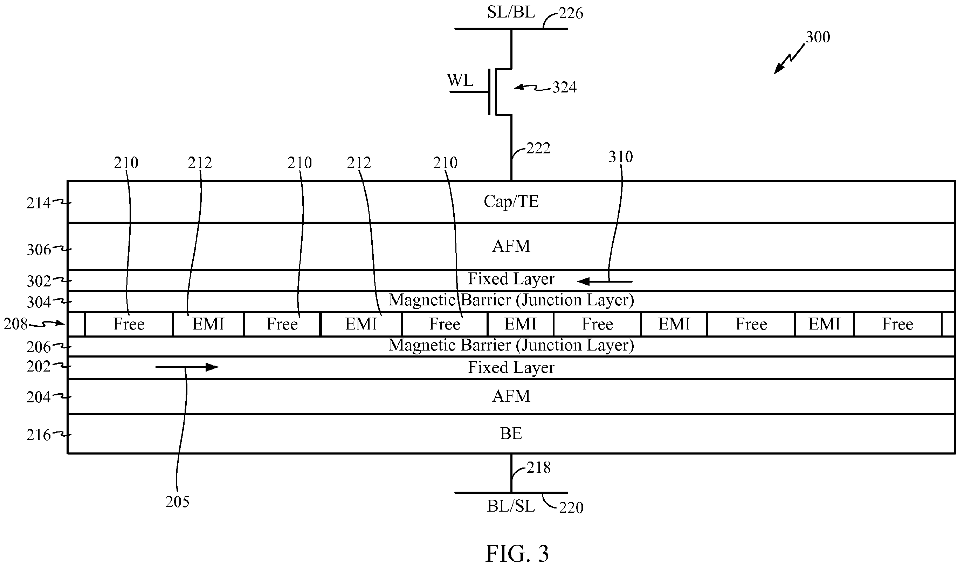

Figure 3 illustrates an STT-MTJ cluster cell memory 300 in which elements common to the previous examples are identified using the same reference numerals. The STT-MTJ cluster cell memory 300 includes a second fixed magnetic layer 302, comprising a unitary layer of material, spaced from the first free magnetic layer 208 by a second magnetic barrier layer 304, also comprising a unitary layer of material. A second anti-ferromagnetic layer 306 is present between the second fixed magnetic layer 302 and the cap layer 214 which helps maintain the magnetic orientation of the second fixed magnetic layer 302 in a direction opposite to that of the first unitary fixed magnetic layer 202 as indicated by an arrow 310, pointing to the left in Figure 3. The cap layer 214 is connected to the source line / bit line 226 by a switch 324. The magnetic state of the plurality of free magnetic islands 210 is programmed probabilistically as described above, and the presence of the second fixed magnetic layer 302 and the second magnetic barrier layer 304 helps provide symmetric read/write characteristics for the first plurality of free magnetic islands 210. This arrangement also improves tunnel magnetoresistance due to the additional junction and also improves state density.

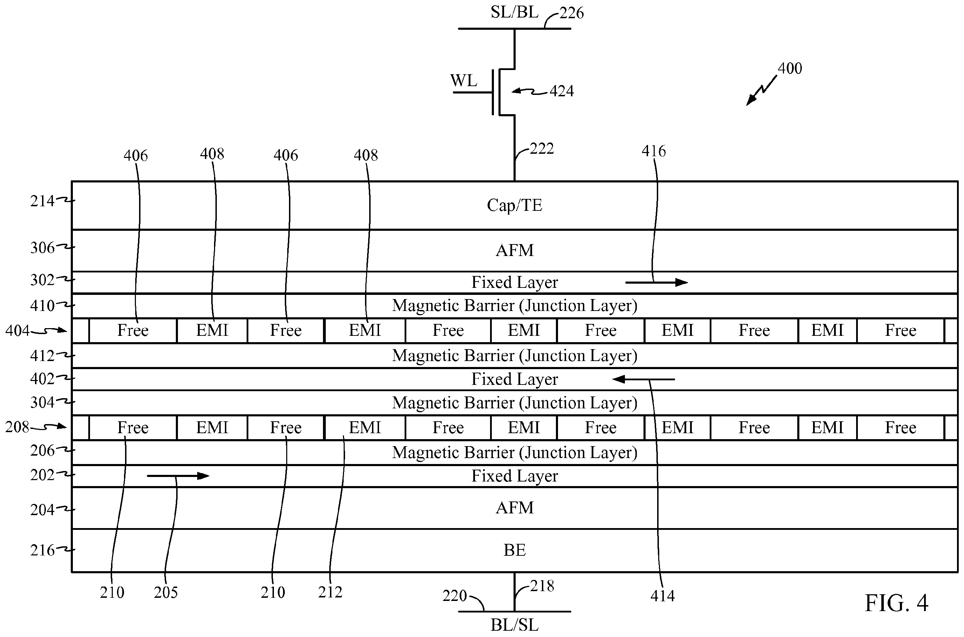

Figure 4 illustrates an STT-MTJ cluster cell memory 400 in which elements common to the previous examples are identified using the same reference numerals. In addition to the layers described above in connection with Figure 3, the STT-MTJ cluster cell memory 400 includes a third fixed magnetic layer 402 between the second magnetic barrier layer 304 and the second fixed magnetic layer 302 and a second free magnetic layer 404 between the second fixed magnetic layer 302 and the third fixed magnetic layer 402. The second free magnetic layer 404 includes a second plurality of free magnetic islands 406 separated by second regions 408 of electromagnetic insulating material. A third magnetic barrier layer 410 extends between the second fixed magnetic layer 302 and the second free magnetic layer 404, and a fourth magnetic barrier layer 412 extends between the second free magnetic layer 404 and the third fixed magnetic layer 402. The directions of the fixed magnetic layers should alternate, and thus the magnetization direction of the first unitary fixed magnetic layer 202 continues to face to the right in Figure 4 as illustrated by arrow 205, the magnetization direction of the third fixed magnetic layer 402 faces in the opposite direction as shown by an arrow 414, and the magnetization direction of the second fixed magnetic layer 302 faces to the right, in the direction of an arrow 416. The cap layer 214 is connected to the source line / bit line 226 by a switch 424. This arrangement provides a second layer of sites having a reversible magnetic state and further improves the state density of the STT-MTJ cluster cell memory 400.

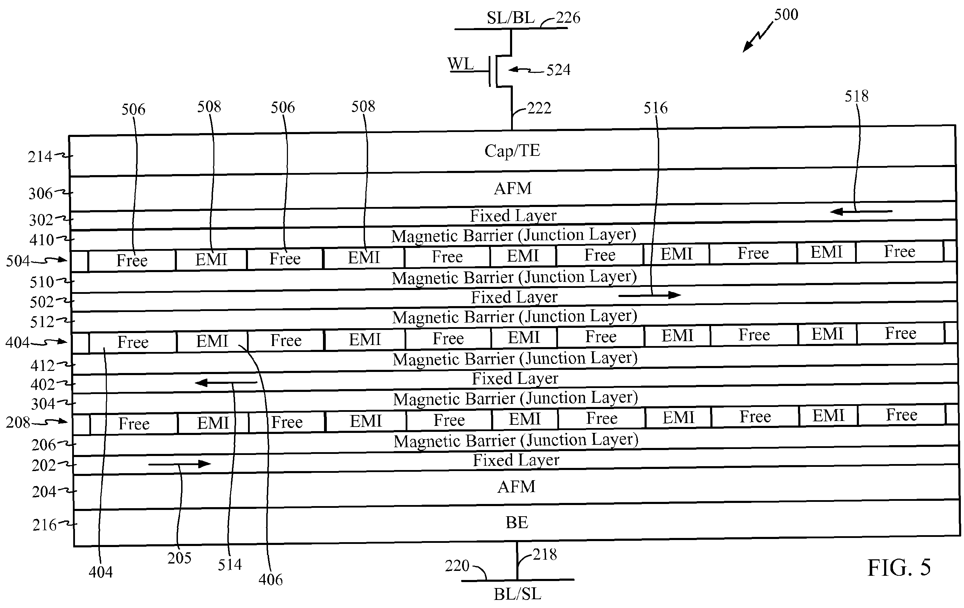

Figure 5 illustrates another STT-MTJ cluster cell memory 500 in which elements common to the previous examples are identified using the same reference numerals. The cluster cell 500 includes a fourth fixed magnetic layer 502 between the second free magnetic layer 404 and the third magnetic barrier layer 410 and a third free magnetic layer 504 comprising a third plurality of free magnetic islands 506 separated by a third plurality of regions 508 of electromagnetic insulating material. A fifth magnetic barrier layer 510 separates the fourth fixed magnetic layer 502 from the third free magnetic layer 504, and a sixth magnetic barrier layer 512 separates the fourth fixed magnetic layer 502 from the second free magnetic layer 404. The magnetization directions of the first through fourth magnetization layers 202, 302, 402 and 502 alternate, and the magnetization direction of the first magnetization layer 202 is illustrated by an arrow 205, to the right in Figure 5, the magnetization direction of the third magnetization layer 302 is to the left in Figure 5 as illustrated by an arrow 514, the magnetization direction of the fourth fixed magnetization layer 502 is to the right as illustrated by an arrow 516 and the magnetization direction of the second fixed magnetization layer 202 is to the left as illustrated by an arrow 518. The cap layer 214 is connected to the source line / bit line 226 by a switch 524. The arrangement of this example further improves state density.

The STT-MTJ cluster cells of the foregoing examples are useful in various fields and devices and may, for example, be integrated into one or more semiconductor dies. The STT-MTJ cluster cells may also be used in various devices including, without limitation, a set top box, a music player, a video player, an entertainment unit, a navigation device, a communications device, a personal digital assistant (PDA), fixed location data unit, or a computer.

A method according to an embodiment includes a block 800 of providing a first unitary fixed magnetic layer, a block 802 of forming a first magnetic barrier layer on the first unitary fixed magnetic layer, a block 804 of forming a first free magnetic layer, comprising a plurality of free magnetic islands, on the first magnetic barrier layer, and a block 806 of providing a cap layer overlying the first free magnetic layer.

Those of skill in the art will appreciate that information and signals may be represented using any of a variety of different technologies and techniques. For example, data, instructions, commands, information, signals, bits, symbols, and chips that may be referenced throughout the above description may be represented by voltages, currents, electromagnetic waves, magnetic fields or particles, optical fields or particles, or any combination thereof.

Further, those of skill in the art will appreciate that the various illustrative logical blocks, modules, circuits, and algorithm steps described in connection with the examples disclosed herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present invention.

The methods, sequences and/or algorithms described in connection with the examples disclosed herein may be embodied directly in hardware, in a software module executed by a processor, or in a combination of the two. A software module may reside in RAM memory, flash memory, ROM memory, EPROM memory, EEPROM memory, registers, hard disk, a removable disk, a CD-ROM, or any other form of storage medium known in the art. An exemplary storage medium is coupled to the processor such that the processor can read information from, and write information to, the storage medium. In the alternative, the storage medium may be integral to the processor.

While the foregoing disclosure shows illustrative examples of the invention, it should be noted that various changes and modifications could be made herein without departing from the scope of the invention as defined by the appended claims. The functions, steps and/or actions of the method claims in accordance with the examples of the invention described herein need not be performed in any particular order. Furthermore, although elements of the invention may be described or claimed in the singular, the plural is contemplated unless limitation to the singular is explicitly stated.

## Claims

1. A spin-torque transfer (STT) magnetic tunnel junction (MTJ) memory comprising:
a first unitary fixed magnetic layer (202);
a first magnetic barrier layer (602) on the first unitary fixed magnetic layer, **characterised in that** the first magnetic barrier layer comprises a first plurality of individual magnetic barrier islands (604);
a first free magnetic layer (208) comprising a first plurality of free magnetic islands (210) disposed on the first plurality of individual magnetic barrier islands (604);
a plurality of regions of electromagnetic isolator material (606) on the first unitary fixed magnetic layer wherein adjacent ones of the free magnetic islands are separated by a region of electromagnetic isolator material and **characterised in that** the first plurality of magnetic barrier islands and the first plurality of regions of electromagnetic isolator material have a coplanar first surface contacting the first unitary fixed magnetic layer; and by a unitary cap layer (214) overlying and directly connected to the first plurality of free magnetic islands and the first plurality of regions of electromagnetic insulator material.

2. The STT-MTJ memory of claim 1, including a first anti-ferromagnetic layer (204) adjacent said first unitary fixed magnetic layer on a side of the first unitary fixed magnetic layer opposite said first magnetic barrier layer.

3. The STT-MTJ memory of claim 2, including a connecting layer adjacent said first anti-ferromagnetic layer and electrically connected to a first line and the STT-MTJ memory including a second line electrically connected to said cap layer.

4. The STT-MTJ memory of claim 1, including a second unitary fixed magnetic layer (302) between said cap layer and said first free magnetic layer and a second magnetic barrier layer (304) between said second unitary fixed magnetic layer and said first free magnetic layer.

5. The STT-MTJ memory of claim 4, wherein said second magnetic barrier layer is connected to said first plurality of free magnetic islands on a side of said first plurality of free magnetic islands opposite from said first magnetic barrier layer.

6. The STT-MTJ memory of claim 4, including a second anti-ferromagnetic layer (306) between said second unitary fixed magnetic layer and said cap layer.

7. The STT-MTJ memory of claim 4, including at least one additional unitary fixed magnetic layer between said second unitary fixed magnetic layer and said first unitary fixed magnetic layer and at least one additional free magnetic layer comprising at least one additional plurality of free magnetic islands.

8. The STT-MTJ memory of claim 4, including a second free magnetic layer (404) comprising a second plurality of free magnetic islands between the second magnetic barrier layer and said first free magnetic layer.

9. The STT-MTJ of claim 8, including a third unitary fixed magnetic layer (402) between said first free magnetic layer and said second free magnetic layer, a third magnetic barrier layer (410) between said third unitary fixed magnetic layer and said second free magnetic layer and a fourth magnetic barrier layer (412) between said third unitary fixed magnetic layer and said first free magnetic layer.

10. The STT-MTJ memory of claim 1 integrated into at least one semiconductor die.

11. The STT-MTJ memory of claim 1 integrated into a device selected from the group consisting of a set top box, a music player, a video player, an entertainment unit, a navigation device, a communications device, a personal digital assistant (PDA), a fixed location data unit, and a computer.

12. A method of forming a spin-torque transfer (STT) magnetic tunnel junction (MTJ) memory comprising:
providing (800) a first unitary fixed magnetic layer;
forming (802) a first magnetic barrier layer on the first unitary fixed magnetic layer;
the method **characterised by**:
forming a plurality of magnetic barrier islands in the first magnetic barrier layer;
forming (804) a first free magnetic layer, comprising a plurality of free magnetic islands, on the plurality of magnetic barrier islands;
forming a first plurality of regions of electromagnetic isolator material on the first unitary fixed magnetic layer wherein adjacent ones of the free magnetic islands are separated by a region of electromagnetic isolator material and wherein the first plurality of magnetic barrier islands and the first plurality of regions of electromagnetic isolator material have a coplanar first surface contacting the first unitary fixed magnetic layer; and
providing (806) a unitary cap layer overlying and directly connected to the first plurality of free magnetic islands and the first plurality of regions of electromagnetic insulator material.

## Patentansprüche

1. Ein Spin-Torque-Transfer (STT)-Magnettunnelübergang (MTJ)-Speicher, aufweisend:
eine erste einheitliche, fixierte Magnetschicht (202),
eine erste Magnetgrenzschicht (602) auf der ersten einheitlichen, fixierten, Magnetschicht, **dadurch gekennzeichnet, dass** die erste Magnetgrenzschicht eine erste Vielzahl von individuellen Magnetgrenzinseln (604) aufweist,
eine erste freie Magnetschicht (208) mit einer ersten Vielzahl von freien Magnetinseln (210), die auf der ersten Vielzahl von individuellen Magnetgrenzinseln (604) angeordnet ist,
eine Vielzahl von Bereichen (606) aus elektromagnetischem Isolatormaterial auf der ersten einheitlichen, fixierten Magnetschicht, wobei benachbarte der freien Magnetinseln durch einen Bereich aus elektromagnetischem Isolatormaterial getrennt sind,
**dadurch gekennzeichnet, dass**:
die erste Vielzahl von Magnetgrenzinseln und die erste Vielzahl von Bereichen aus elektromagnetischem Isolatormaterial eine koplanare erste Fläche aufweisen, die die erste einheitliche, fixierte Magnetschicht kontaktiert, und
eine einheitliche Kappenschicht (214), die über der ersten Vielzahl von freien Magnetinseln und der ersten Vielzahl von Bereichen aus elektromagnetischem Isolatormaterial liegt und direkt mit diesen verbunden ist.

2. STT-MTJ-Speicher nach Anspruch 1, der eine erste antiferromagnetische Schicht (204) enthält, die der ersten einheitlichen, fixierten Magnetschicht auf einer Seite der ersten einheitlichen, fixierten Magnetschicht gegenüber der ersten Magnetgrenzschicht benachbart ist.

3. STT-MTJ-Speicher nach Anspruch 2, der eine Verbindungsschicht enthält, die der ersten anti-ferromagnetischen Schicht benachbart ist und elektrisch mit einer ersten Leitung verbunden ist, und weiterhin eine zweite Leitung enthält, die elektrisch mit der Kappenschicht verbunden ist.

4. STT-MTJ-Speicher nach Anspruch 1, der eine zweite einheitliche, fixierte Magnetschicht (302) zwischen der Kappenschicht und der ersten freien Magnetschicht und eine zweite Magnetgrenzschicht (304) zwischen der zweiten einheitlichen, fixierten Magnetschicht und der ersten freien Magnetschicht enthält.

5. STT-MTJ-Speicher nach Anspruch 4, wobei die zweite Magnetgrenzschicht mit der ersten Vielzahl von freien Magnetinseln auf einer Seite der ersten Vielzahl von freien Magnetinseln gegenüber der ersten Magnetgrenzschicht verbunden ist.

6. STT-MTJ-Speicher nach Anspruch 4, der eine zweite antiferromagnetische Schicht (306) zwischen der zweiten einheitlichen, fixierten Magnetschicht und der Kappenschicht enthält.

7. STT-MTJ-Speicher nach Anspruch 4, der wenigstens eine zusätzliche einheitliche, fixierte Magnetschicht zwischen der zweiten einheitlichen, fixierten Magnetschicht und der ersten einheitlichen, fixierten Magnetschicht und wenigstens eine zusätzliche freie Magnetschicht mit wenigstens einer zusätzlichen Vielzahl von freien Magnetinseln enthält.

8. STT-MTJ-Speicher nach Anspruch 4, der eine zweite freie Magnetschicht (404) mit einer zweiten Vielzahl von freien Magnetinseln zwischen der zweiten Magnetgrenzschicht und der ersten freien Magnetschicht aufweist.

9. STT-MTJ-Speicher nach Anspruch 8, der eine dritte einheitliche, fixierte Magnetschicht (402) zwischen der ersten freien Magnetschicht und der zweiten freien Magnetschicht, eine dritte Magnetgrenzschicht (410) zwischen der dritten einheitlichen, fixierten Magnetschicht und der zweiten freien Magnetschicht und eine vierte Magnetgrenzschicht (412) zwischen der dritten einheitlichen, fixierten Magnetschicht und der ersten freien Magnetschicht enthält.

10. STT-MTJ-Speicher nach Anspruch 1, der in wenigstens einem Halbleiter-Die integriert ist.

11. STT-MTJ-Speicher nach Anspruch 1, der in einem Gerät integriert ist, das aus der Gruppe ausgewählt ist, die eine Set-Top-Box, einen Musikplayer, einen Videoplayer, eine Unterhaltungseinheit, ein Navigationsgerät, ein Kommunikationsgerät, einen PDA, eine fixierte Positionsdateneinheit und einen Computer umfasst.

12. Ein Verfahren zum Herstellen eines Spin-Torque-Transfer (STT)-Magnettunnelübergang (MTJ)-Speichers, das folgende Schritte aufweist:
Vorsehen (800) einer ersten einheitlichen, fixierten Magnetschicht,
Ausbilden (802) einer ersten Magnetgrenzschicht auf der ersten einheitlichen, fixierten Magnetschicht,
wobei das Verfahren **gekennzeichnet ist durch**:
Ausbilden einer Vielzahl von Magnetgrenzinseln in der ersten Magnetgrenzschicht,
Ausbilden (804) einer ersten freien Magnetschicht mit einer Vielzahl von freien Magnetinseln auf der Vielzahl von Magnetgrenzinseln,
Ausbilden einer ersten Vielzahl von Bereichen aus elektromagnetischem Isolatormaterial auf der ersten einheitlichen, fixierten Magnetschicht, wobei benachbarte der freien Magnetinseln **durch** einen Bereich aus elektromagnetischem Isolatormaterial getrennt sind und wobei die erste Vielzahl von Magnetgrenzinseln und die erste Vielzahl von Bereichen von elektromagnetischem Isolatormaterial eine koplanare erste Fläche aufweisen, die die erste einheitliche, fixierte Magnetschicht kontaktiert, und
Vorsehen (806) einer einheitlichen Kappe, die über der ersten Vielzahl von freien Magnetinseln und der ersten Vielzahl von Bereichen aus elektromagnetischem Isolatormaterial liegt und direkt mit diesen verbunden ist.

## Revendications

1. Mémoire de jonction à effet tunnel magnétique (MTJ) à transfert de couple de spin (STT) comprenant :
une première couche magnétique fixe unitaire (202) ;
une première couche formant barrière magnétique (602) sur la première couche magnétique fixe unitaire, **caractérisée en ce que** la première couche formant barrière magnétique comprend une première pluralité d'îlots formant barrière magnétique individuels (604) ;
une première couche magnétique libre (208) comprenant une première pluralité d'îlots magnétiques libres (210) disposés sur la première pluralité d'îlots formant barrière magnétique individuels (604);
une pluralité de régions d'un matériau d'isolation électromagnétique (606) sur la première couche magnétique fixe unitaire, dans lequel des îlots adjacents parmi les îlots magnétiques libres sont séparés par une région d'un matériau d'isolation électromagnétique et **caractérisée en ce que** la première pluralité d'îlots formant barrière magnétique et la première pluralité de régions d'un matériau d'isolation électromagnétique présentent une première surface coplanaire en contact avec la première couche magnétique fixe unitaire ; et par une couche de recouvrement unitaire (214) sus-jacente et directement connectée à la première pluralité d'îlots magnétiques libres et la première pluralité de régions d'un matériau d'isolation électromagnétique.

2. La mémoire STT-MTJ selon la revendication 1, comprenant une première couche anti-ferromagnétique (204) adjacente à ladite première couche magnétique fixe unitaire sur un côté de la première couche magnétique fixe unitaire opposé à ladite première couche formant barrière magnétique.

3. La mémoire STT-MTJ selon la revendication 2, comprenant une couche de liaison adjacente à ladite première couche anti-ferromagnétique et connectée électriquement à une première ligne, et la mémoire STT-MTJ comportant une deuxième ligne connectée électriquement à ladite couche de recouvrement.

4. La mémoire STT-MTJ de la revendication 1, comprenant une deuxième couche magnétique fixe unitaire (302) entre ladite couche de recouvrement et ladite première couche magnétique libre et une deuxième couche formant barrière magnétique (304) entre ladite deuxième couche magnétique fixe unitaire et ladite première couche magnétique libre.

5. La mémoire STT-MTJ selon la revendication 4, dans laquelle ladite deuxième couche formant barrière magnétique est connectée à ladite première pluralité d'îlots magnétiques libres sur un côté de ladite première pluralité d'îlots magnétiques libres opposé à ladite première couche formant barrière magnétique.

6. La mémoire STT-MTJ selon la revendication 4, comprenant une deuxième couche anti-ferromagnétique (306) entre ladite deuxième couche magnétique fixe unitaire et ladite couche de recouvrement.

7. La mémoire STT-MTJ selon la revendication 4, comprenant au moins une couche magnétique supplémentaire fixe unitaire entre ladite deuxième couche magnétique fixe unitaire et ladite première couche magnétique fixe unitaire et au moins une couche magnétique libre supplémentaire comprenant au moins une pluralité supplémentaire d'îlots magnétiques libres.

8. La mémoire STT-MTJ selon la revendication 4, comprenant une deuxième couche magnétique libre (404) comprenant une deuxième pluralité d'îlots magnétiques libres entre la deuxième couche barrière magnétique et ladite première couche magnétique libre.

9. La mémoire STT-MTJ selon la revendication 8, qui comprend une troisième couche magnétique fixe unitaire (402) entre ladite première couche magnétique libre et ladite deuxième couche magnétique libre, une troisième couche formant barrière magnétique (410) entre ladite troisième couche magnétique fixe unitaire et ladite deuxième couche magnétique libre et une quatrième couche formant barrière magnétique (412) entre ladite troisième couche magnétique fixe unitaire et ladite première couche magnétique libre.

10. La mémoire STT-MTJ selon la revendication 1 intégrée dans au moins une puce semi-conductrice.

11. La mémoire STT-MTJ de la revendication 1 intégrée dans un dispositif choisi dans le groupe composé d'un boîtier de décodeur, un lecteur de musique, un lecteur vidéo, une unité de divertissement, un appareil de navigation, un dispositif de communication, un assistant numérique personnel (PDA), une unité de données à position déterminée, et un ordinateur.

12. Procédé de formation d'une mémoire de jonction à effet tunnel magnétique (MTJ) à transfert de couple de spin (STT) comprenant :
la fourniture (800) d'une première couche magnétique fixe unitaire;
la formation (802) d'une première couche formant barrière magnétique sur la première couche magnétique fixe unitaire ;
le procédé étant **caractérisé par** :
la formation d'une pluralité d'îlots formant barrière magnétique dans la première couche formant barrière magnétique ;
la formation (804) d'une première couche magnétique libre comprenant une pluralité d'îlots magnétiques libres disposés sur la pluralité d'îlots formant barrière magnétique ;
la formation d'une première pluralité de régions d'un matériau d'isolation électromagnétique sur la première couche magnétique fixe unitaire, dans lequel des îlots adjacents parmi les îlots magnétiques libres sont séparés par une région d'un matériau d'isolation électromagnétique et dans lequel la première pluralité d'îlots formant barrière magnétique et la première pluralité de régions d'un matériau d'isolation électromagnétique présentent une première surface coplanaire en contact avec la première couche magnétique fixe unitaire ; et
la fourniture (806) d'une couche de recouvrement unitaire sus-jacente et directement connectée à la première pluralité d'îlots magnétiques libres et la première pluralité de régions d'un matériau d'isolation électromagnétique.
